# EUROPEAN PATENT APPLICATION

(11) **EP 3 462 606 A1**
(43) Date of publication of application: **03.04.2019**
(21) Application number: 18181526.7
(22) Date of filing: 03.07.2018
(51) Int. Cl.: H02S 30/00, F24S 25/60

(54) **BACK-HANG MOUNTING ASSEMBLY OF THIN FILM PHOTOVOLTAIC MODULE**

(30) Priority: 28.09.2017 CN 201721265816 U
(71) Applicant: Beijing Apollo Ding Rong Solar Technology Co., Ltd., Beijing 100176 (CN)
(72) Inventor: Jiang, Wei, Beijing, 100176 (CN); Lv, Hejiang, Beijing, 100176 (CN); Wang, Hong, Beijing, 100176 (CN)
(74) Representative: Schüssler, Andrea

(57) **Abstract**

The disclosure provides a back-hang mounting assembly of a thin film photovoltaic module, which includes: a back-hang hook plate and a cross beam, wherein the cross section of the back-hang hook plate is F-shaped and it is fixedly connected to the photovoltaic module. The cross beam is configured to be fixedly connected to a roof and fixed to the back-hang hook plate by the hook joint. The back-hang mounting assembly provided by the disclosure can avoid the damage to the glass, and furthermore the structure is simple and the installation is relatively convenient.

## Description

### Field

The disclosure relates to the mounting technique of the photovoltaic module, and particularly to a back-hang mounting assembly of a thin film photovoltaic module.

### Background

The solar energy is a kind of clean energy, of which the exploitation and utilization are valued by various countries in the world. How to efficiently collect and utilize the solar energy is fairly far-reaching for the environmental protection. The thin film is the future of the photovoltaic power generation, particularly along with the further improvement of the module efficiency, and the flexibility and thin film tendency will become the emerging development direction of the photovoltaic market gradually. But the thin film modules are mostly the frameless double-glazed modules, where the thin film modules have the higher installation breakage rate due to their special double-glazed structure and the improper operations in the installation.

The fixation of the thin film photovoltaic module in the related art needs to use the clamp to impact and fix in the front plate direction of the module, which often causes the breakage phenomenon of the pressed module glass due to the overexertion. Meanwhile there are the problems of blocking the light rays and affecting the electric energy production, and the installation operations are inconvenience and the construction progress is slow.

### Summary

The object of the disclosure is to provide a back-hang mounting assembly of a thin film photovoltaic module, to address the problem in the prior art, avoid the damage to the glass, and be convenient to install.

The disclosure provides a back-hang mounting assembly of a thin film photovoltaic module, which includes: a back-hang hook plate of which a cross section is F-shaped and which is fixedly connected to the photovoltaic module; a cross beam configured to be fixedly connected to a roof and fixed to the back-hang hook plate by hook joint.

In some embodiments, in the back-hang mounting assembly, the back-hang hook plate is fixedly connected to a glass back plate of the photovoltaic module.

In some embodiments, in the back-hang mounting assembly, the back-hang hook plate includes a horizontal plate, a first L-shaped plate and a second L-shaped plate, wherein the horizontal plate is fixedly connected to the glass back plate, a first end of the first L-shaped plate and a first end of the second L-shaped plate are both fixed on the horizontal plate, and a second end of the first L-shaped plate and a second end of the second L-shaped plate both form hook shapes bending towards a same direction and having different heigths; the cross beam includes a base plate, a third L-shaped plate and a fourth L-shaped plate, wherein the base plate is configured to be fixedly connected to the roof, a first end of the third L-shaped plate and a first end of the fourth L-shaped plate are both fixed on the base plate, a second end of the third L-shaped plate and a second end of the fourth L-shaped plate both form hook shapes bending towards a same direction and having different heigths, the third L-shaped plate is hooked to the first L-shaped plate, and the fourth L-shaped plate is hooked to the second L-shaped plate.

In some embodiments, in the back-hang mounting assembly, the horizontal plate is fixedly connected to the glass back plate via a structural adhesive.

In some embodiments, the back-hang mounting assembly further includes a limit bolt, which passes through the first L-shaped plate and then presses against the third L-shaped plate; and/or, which passes through the fourth L-shaped plate and then presses against the second L-shaped plate.

In some embodiments, the back-hang mounting assembly further includes a first fixing bolt which passes through the base plate and is then fixedly connected to the first L-shaped plate and/or second L-shaped plate.

In some embodiments, the back-hang mounting assembly further includes an oblique beam on which the base plate is fixed and which is configured to be fixedly connected to the roof.

In some embodiments, the back-hang mounting assembly further includes a second fixing bolt which passes through the base plate and is then fixedly connected to the oblique beam.

In some embodiments, the back-hang mounting assembly further includes a pillar of which a top end is fixedly connected to a side of the oblique beam far from the base plate and a bottom end is fixedly connected to the roof.

In some embodiments, in the back-hang mounting assembly, the material of the back-hang hook plate is aluminium alloy.

In some embodiments, in the back-hang mounting assembly, the number of back-hang hook plates is two, and two back-hang hook plates are perpendicular or parallel to each other.

The back-hang mounting assembly of the thin film photovoltaic module provided by the disclosure includes the back-hang hook plate of which the cross section is F-shaped, where one end thereof is fixedly connected to the photovoltaic module, and the other end is fixed to the cross beam by the hook joint and then connected to the roof by the cross beam, to thereby implement the installation of the photovoltaic module on the roof. Compared with the prior art, the damage to the glass is avoided, and furthermore the structure is simple and the installation is relatively convenient.

### Brief Description of the Drawings

FIG.1 is a schematic structural diagram of a back-hang mounting assembly of a thin film photovoltaic module in accordance with an embodiment of the disclosure;
FIG.2 is a front view of a back-hang mounting assembly of a thin film photovoltaic module in accordance with an embodiment of the disclosure;
FIG.3 is an enlarged view of the part A in FIG.2; and
FIG.4 is a schematic overall diagram of a back-hang mounting assembly of a thin film photovoltaic module in accordance with an embodiment of the disclosure.

### Detailed Description

In order to make the objects, technical solutions and advantages of the disclosure clearer, the technical solutions of the embodiments of the disclosure will be described clearly and completely below in combination with the accompanying drawings of the embodiments of the disclosure. Obviously the described embodiments are a part of the embodiments of the disclosure but not all the embodiments. Based upon the embodiments of the disclosure, all of other embodiments obtained by those ordinary skilled in the art without creative work pertain to the protection scope of the disclosure.

The embodiments of the disclosure will be described below in details and the examples of these embodiments are shown in the drawings, in which the same or similar reference numbers represent the same or similar elements or the elements having the same or similar functions all the way. The embodiments described by reference to the drawings are exemplary and only used to explain the disclosure, but not interpreted as the limitations of the disclosure.

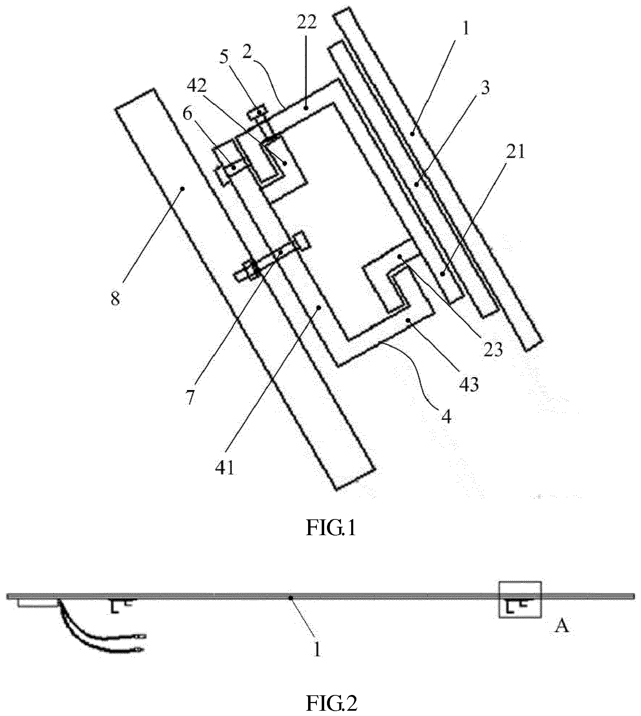

As shown in FIGs.1 to 3, an embodiment of the disclosure provides a back-hang mounting assembly of a thin film photovoltaic module, which includes a back-hang hook plate 2 and a cross beam 4. The cross section of the back-hang hook plate 2 is F-shaped, the back-hang hook plate 2 is fixedly connected to the photovoltaic module, and the cross beam 4 is configured to be fixedly connected to a roof and fixed to the back-hang hook plate 2 by the hook joint.

The back-hang mounting assembly of the thin film photovoltaic module according to the embodiment of the disclosure includes the back-hang hook plate 2 of which the cross section is similar to the F shape, where one end thereof is fixedly connected to the photovoltaic module, and the other end is fixed to the cross beam 4 by the hook joint and then connected to the roof by the cross beam 4, to thereby implement the installation of the photovoltaic module on the roof. Compared with the related art, the damage to the glass is avoided, and furthermore the structure is simple and the installation is relatively convenient.

In some embodiments, as shown in FIGs.1 to 3, the photovoltaic module includes a glass back plate 1, a thin film solar battery chip and a glass top plate superposed successively. FIG.1 only shows the glass back plate 1 exemplarily, and actually, the thin film solar battery chip and the glass top plate are superposed successively on the glass back plate 1 to form the double-glazed module. It can be understood by those skilled in the art that the mounting assembly according to the embodiment is not limited to being used on the double-glazed module, and the purpose thereof is to avoid the direct clamping of the back plate, so the applicable range of the mounting assembly is larger and not limited to the double-glazed module mentioned in the embodiment. The double-glazed module in the embodiment contains a front plate of tempered glass with an antireflection coating, of which the length and width size is 1190*789.5mm and the thickness is 4mm. The glass back plate is the float glass, of which the length and width size is 1190*789.5mm and the thickness is 3mm. The selection of the float glass can reduce the attenuation of the photovoltaic module and increase the photoelectric conversion efficiency.

The back-hang hook plate 2 of the mounting assembly is fixedly connected to the glass back plate 1 of the photovoltaic module.

In some embodiments, the back-hang hook plate 2 includes a horizontal plate 21, a first L-shaped plate 22 and a second L-shaped plate 23. The horizontal plate 21 is fixedly connected to the glass back plate 1, the first end of the first L-shaped plate 22 and the first end of the second L-shaped plate 23 are both fixed on the horizontal plate 21, and the second end of the first L-shaped plate 22 and the second end of the second L-shaped plate 23 both form the hook shapes bending towards the same direction and having different heigths. The back-hang hook plate 2 forms the structure of which the cross section is similar to the F shape.

The cross beam 4 includes a base plate 41, a third L-shaped plate 42 and a fourth L-shaped plate 43. The base plate 41 is configured to be fixedly connected to the roof, the first end of the third L-shaped plate 42 and the first end of the fourth L-shaped plate 43 are both fixed on the base plate 41, the second end of the third L-shaped plate 42 and the second end of the fourth L-shaped plate 43 both form the hook shapes bending towards the same direction and having different heigths, the third L-shaped plate 42 is hooked to the first L-shaped plate 22, and the fourth L-shaped plate 43 is hooked to the second L-shaped plate 23. The cross beam 4 forms the structure of which the cross section is similar to the F shape.

The back-hang mounting assembly of the thin film photovoltaic module according to the embodiment of the disclosure includes the back-hang hook plate 2 of which the cross section is similar to the F shape, where one end thereof is fixedly connected to the glass back plate 1 of the photovoltaic module, and the other end is fixed to the cross beam 4 by the hook joint and then connected to the roof by the cross beam 4, to thereby implement the installation of the photovoltaic module on the roof. Compared with the related art, the damage to the glass is avoided, and furthermore the structure is simple and the installation is relatively convenient.

In some embodiments, the back-hang hook plate 2 is fixedly connected to the glass back plate 1 via the structural adhesive 3. It can be understood that the back-hang hook plate 2 may also be fixedly connected to the glass back plate 1 by the rivet joint, screw joint or others.

In some embodiments, the mounting assembly further includes a limit bolt 5, which passes through the first L-shaped plate 22 and then presses against the third L-shaped plate 42; and/or, which passes through the fourth L-shaped plate 43 and then presses against the second L-shaped plate 23, to thereby limit the relative motion of the back-hang hook plate 2 and the cross beam 4.

In some embodiments, the mounting assembly further includes a first fixing bolt 6. The first fixing bolt 6 passes through the base plate 41 and is then fixedly connected to the first L-shaped plate 22 and/or second L-shaped plate 23.

In some embodiments, the mounting assembly further includes an oblique beam 8. The base plate 41 of the cross beam 4 is fixed on the oblique beam 8, and the oblique beam 8 is configured to be fixedly connected to the roof. The mounting assembly may further include a second fixing bolt 7. The second fixing bolt 7 passes through the base plate 41 and is then fixedly connected to the oblique beam 8. The stable connections between the cross beam 4 and the back-hang hook plate 2 and between the cross beam 4 and the oblique beam 8 are achieved by arranging the first fixing bolt 6 and the second fixing bolt 7.

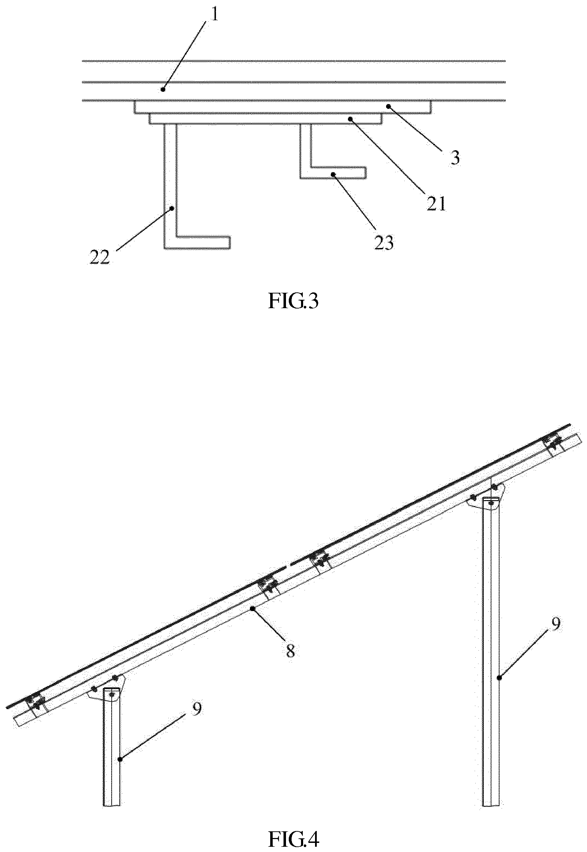

As shown in FIG.4, based on the above embodiments, the back-hang mounting assembly of the thin film photovoltaic module according to an embodiment of the disclosure further includes a pillar 9. The top end of the pillar 9 is fixedly connected to the side of the oblique beam 8 far from the base plate 41 and the bottom end of the pillar 9 is fixedly connected to the roof. The pillar 9 may be fixedly connected to the oblique beam 8 by a bracket, the photovoltaic module is supported at a certain height by arranging the pillar 9, and the photovoltaic module is inclined at a certain angle by arranging the oblique beam 8, to thereby absorb the light better and increase the transformation efficiency of the electric energy.

The number of the back-hang hook plates 2 can be set according to the size of the photovoltaic module. In some embodiments, there are two back-hang hook plates 2 and two back-hang hook plates 2 are perpendicular or parallel to each other to increase the installation strength of the photovoltaic module. The material of the back-hang hook plate 2 may be the aluminium alloy, to thereby implement the lightweighting of the mounting structure.

The back-hang mounting assembly of the thin film photovoltaic module according to the disclosure includes the back-hang hook plate of which the cross section is similar to the F shape, where one end thereof is fixedly connected to the photovoltaic module, and the other end is fixed to the cross beam by the hook joint and then connected to the roof by the cross beam, to thereby implement the installation of the photovoltaic module on the roof. Compared with the related art, the damage to the glass is avoided, and furthermore the structure is simple and the installation is relatively convenient.

The above embodiments shown by the drawings illustrate the constructions, features and effects of the disclosure in details, and the above embodiments are only the preferred embodiments of the disclosure, but the disclosure does not limit the implementation scope by the graphical representations. All the variations or modifications into the equivalent embodiments with the equivalent changes made based on the conception of the disclosure should come into the protection scope of the disclosure without departing from the spirit encompassed by the specification and drawings.

## Claims

1. A back-hang mounting assembly of a thin film photovoltaic module, **characterized in that**, comprising:
a back-hang hook plate of which a cross section is F-shaped and which is fixedly connected to the photovoltaic module; and
a cross beam configured to be fixedly connected to a roof and fixed to the back-hang hook plate by hook joint.

2. The back-hang mounting assembly according to claim 1, wherein the back-hang hook plate is fixedly connected to a glass back plate of the photovoltaic module.

3. The back-hang mounting assembly according to claim 2, wherein:
the back-hang hook plate comprises a horizontal plate, a first L-shaped plate and a second L-shaped plate, wherein the horizontal plate is fixedly connected to the glass back plate, a first end of the first L-shaped plate and a first end of the second L-shaped plate are both fixed on the horizontal plate, and a second end of the first L-shaped plate and a second end of the second L-shaped plate both form hook shapes bending towards a same direction and having different heigths;
the cross beam comprises a base plate, a third L-shaped plate and a fourth L-shaped plate, wherein the base plate is configured to be fixedly connected to the roof, a first end of the third L-shaped plate and a first end of the fourth L-shaped plate are both fixed on the base plate, a second end of the third L-shaped plate and a second end of the fourth L-shaped plate both form hook shapes bending towards a same direction and having different heigths, the third L-shaped plate is hooked to the first L-shaped plate, and the fourth L-shaped plate is hooked to the second L-shaped plate.

4. The back-hang mounting assembly according to claim 3, wherein the horizontal plate is fixedly connected to the glass back plate via a structural adhesive.

5. The back-hang mounting assembly according to claim 3, further comprising a limit bolt, which passes through the first L-shaped plate and then presses against the third L-shaped plate; and/or, which passes through the fourth L-shaped plate and then presses against the second L-shaped plate.

6. The back-hang mounting assembly according to claim 3, further comprising a first fixing bolt which passes through the base plate and is then fixedly connected to the first L-shaped plate and/or second L-shaped plate.

7. The back-hang mounting assembly according to any one of claims 3-6, further comprising an oblique beam on which the base plate is fixed and which is configured to be fixedly connected to the roof.

8. The back-hang mounting assembly according to claim 7, further comprising a second fixing bolt which passes through the base plate and is then fixedly connected to the oblique beam.

9. The back-hang mounting assembly according to claim 7, further comprising a pillar of which a top end is fixedly connected to a side of the oblique beam far from the base plate and a bottom end is fixedly connected to the roof.

10. The back-hang mounting assembly according to any one of claims 1-6, wherein the material of the back-hang hook plate is aluminium alloy.

11. The back-hang mounting assembly according to claim 10, wherein the number of back-hang hook plates is two, and two back-hang hook plates are perpendicular or parallel to each other.
